**Europäisches Patentamt**

**European Patent Office**

**Office européen des brevets**

(11) Veröffentlichungsnummer: **0 025 927**

**A2**

(12) **EUROPÄISCHE PATENTANMELDUNG**

(21) Anmeldenummer: **80105355.4**

(22) Anmeldetag: **08.09.80**

(51) Int. Cl.³: **D 06 Q 1/04**

(30) Priorität: **19.09.79 DE 2937874**

(43) Veröffentlichungstag der Anmeldung:
**01.04.81 Patentblatt 81/13**

(84) Benannte Vertragsstaaten:
**BE CH DE FR GB IT LI NL SE**

(71) Anmelder: **BAYER AG**
**Zentralbereich Patente, Marken und Lizenzen**
**D-5090 Leverkusen 1, Bayerwerk(DE)**

(72) Erfinder: **Ebneth, Harold, Dr.**
**Berta-von-Suttner-Strasse 61**
**D-5090 Leverkusen(DE)**

(72) Erfinder: **Wolf, Gerhard Dieter, Dr.**
**Wilhelm-Busch-Strasse 29**
**D-4047 Dormagen 5(DE)**

(54) **Vergoldete, metallisierte, textile Flächengebilde, Garne und Fasern, Verfahren zu ihrer Herstellung und Verwendung des Textilgutes bei der Absorption und Reflexion von Mikrowellen.**

㉗ Auf textilen Flächengebilden wird naßchemisch, stromlos eine Kupfer-oder eine Kupfer/Nickel-Schicht mit einer Dicke zwischen 0,05 und 1 μm aufgebracht, und auf dieser wird naßchemisch, stromlos soviel Gold abgeschieden, daß der Oberflächenwiderstand unter 10 Ohm liegt. Das vergoldete Textilgut ist besonders geeignet zur Abschirmung von Mikrowellen und Hochfrequenzstrahlung und zur Herstellung reflektierender Elemente für elektromagnetische Strahlung.

**EP 0 025 927 A2**

BAYER AKTIENGESELLSCHAFT    5090 Leverkusen, Bayerwerk

Zentralbereich
Patente, Marken und Lizenzen    Hö/bc/c    18. Sep. 1979

Vergoldete, metallisierte, textile Flächengebilde, Garne
und Fasern, Verfahren zu ihrer Herstellung und Verwendung
des Textilgutes bei der Absorption und Reflexion von
Mikrowellen

Die Verwendung metallisierter, textiler Flächengebilde zur Abschirmung und als reflektierendes Material für Mikrowellen- und Hochfrequenzstrahlung ist an sich bekannt. Die Metallisierung des Textilgutes erfolgt dabei bevorzugt stromlos, naßchemisch, wie es beispielsweise in der DE-OS 27 43 768 beschrieben ist. Der Einsatz metallisierter, textiler Flächengebilde erfolgt bis jetzt hauptsächlich in der Medizin, Raumfahrt und Elektrotechnik, wo sie vor allem deswegen geschätzt sind, weil sie einerseits ihren textilen Charakter, also leichte, flexible, textilelastische, anschmiegsame Gewebe, Gewirke und Gestricke, bewahrt haben und der elektrische Widerstand niedrig ist, was Voraussetzung für eine hohe Reflexion bzw. Absorption elektromagnetischer Strahlung ist.

Es gibt aber auch Bereiche, wo das Eigenschaftsbild bisher bekannter metallisierter, textiler Flächenge-

Le A 19 889

bilde nicht befriedigt bzw. noch nicht ausreicht. In Sonderfällen ist es erforderlich, den Widerstand metallisierter textiler Flächengebilde weiter zu erniedrigen. Dazu kommt, daß gerade bei vernickelten Textilen bei Oberflächen in ungeschütztem Zustand ein störender Abrieb von Nickelmetallstaub auftreten kann. Verkupferte Textilien sind oxidationsempfindlich; besonders in feuchter Umgebung bei Temperaturen von über 50°C tritt unter Dunkelfärbung der Metalloberfläche eine Zunahme des elektrischen Widerstandes auf. Bei einer Vergoldung von textilen Flächengebilden nach dem in der DE-OS 27 43 768 beschriebenen Verfahren erhält man kein Textilgut mit sehr hoher Leitfähigkeit, das Metall wird nicht in goldglänzender Form abgeschieden, sondern das Textilgut nur violett angefärbt. Die Farbe ist ähnlich wie die des Cassius'schen Goldpurpurs; es wird kein Goldglanz erreicht. Auch wenn man versucht, vernickelte textile Flächengebilde stromlos naßchemisch zu vergolden, erhält man kein textiles Flächengebilde mit einem guten metallisch goldglänzenden Aussehen und den gesuchten niederohmigen Eigenschaften.

Es wurde nun überraschend gefunden, daß naßchemisch stromlos eine spontane metallische Vergoldung möglich ist, wenn man von textilen Flächengebilden ausgeht, auf denen zunächst eine Kupfer- oder eine Nickel/Kupfer-, Schicht aufgebracht worden ist.

Gegenstand der Erfindung sind textile Flächengebilde, Garne und Fasern von metallisch glänzendem Aussehen mit einer unteren Metallschicht aus Kupfer oder Nickel/ Kupfer, mit einer

Le A 19 889

Dicke zwischen 0,05µm bis 1µm und einer oberen Schicht aus Gold, bevorzugt mit einem Oberflächenwiderstand von höchstens 10 Ohm, gemessen nach DIN 54345 bei 23°C und 50 % rel. Feuchtigkeit, ein Verfahren zu deren Herstellung, wobei die Metalle nacheinander naßchemisch stromlos abgeschieden werden können, sowie deren Verwendung als Material für und zur Abschirmung von Mikrowellen und Hochfrequenzstrahlung.

Es ist charakteristisch, daß bereits eine sehr dünne metallische Kupferschicht von beispielsweise 0,05µm aureicht, um bei der naßchemischen Vergoldung einen hellen metallisch-glänzenden Goldüberzug zu erhalten. Eine schnelle Überführung der verkupferten Probe in das Goldbad ist zweckmäßig. Auch bei dickern (z.B. $\geq$ 0,5µm) Kupferüberzügen des textilen Flächengebildes ist eine anschließende Vergoldung in jedem Fall möglich. Der textile Charakter der textilen Flächengebilde, Garne und Spinnfasern, geht trotz der doppelten Metallisierung mit zwei verschiedenen Metallen nacheinander nicht verloren. Die hohe Leitfähigkeit des Goldes kommt voll zur Wirkung.

Die stromlose Verkupferung ist beispielsweise in der DE-OS 27 43 768 beschrieben, Goldrezepturen beispielsweise in dem US-Patent 3 697 295 oder in W. Goldie, Metallic Coating of Plastics, Vol. I, Middelesex, England, Electrochemical Publications Ltd. (1968), S. 99/103. Die nachfolgend beschriebenen Rezepturen ergeben gut reagierende Goldsalzlösungen.

Le A 19 889

- 4 -

Man löst 4 g Goldchlorid in 1 l Wasser auf und stellt eine wäßrige Reduktionslösung aus 32 g/l Kaliumcarbonat, 4 g/l Saccharose und 4 cm$^3$/l Formaldehyd her. Gleiche Teile aus beiden Lösungen werden miteinander vermischt.

Die Zusammensetzung zweier weiterer Goldbäder ist in der nachfolgenden Tabelle dargestellt:

| Bad | 1 | 2 |
|---|---|---|
| | Konzentr. in g/l | |
| Kaliumgoldcyanid $KAu(CN)_2$ | 28 | 2 |
| Citronensäure $C_6H_8O_7 \cdot H_2O$ | 60 | - |
| Natriumcitrat $Na_3C_6H_5O_7 \cdot 5\ 1/2\ H_2O$ | - | 50 |
| Monokaliumphthalat $KC_8H_5O_4$ | 25 | - |
| Ammoniumchlorid $NH_4Cl$ | - | 75 |
| Wolframsäure $H_2WO_4$ | 45 | - |
| Natriumhydroxyd NaOH | 16 | - |
| Natriumhypophosphit $NaH_2PO_2 \cdot H_2O$ | - | 10 |
| N,N-Diethylglycin (Na-Salz) | 3,75 | - |
| pH-Wert | 5-6 | 7,0-7,5 |
| Temperatur in °C | 85-95 | 90-95 |
| Abscheidungsgeschwindigkeit in µm/h | ca. 0,3 | 0,3-7,5 |

Diese im alkalischen Bereich arbeitenden reduktiven Goldbäder werden in einem Temperaturbereich ab 70°C aufwärts betrieben. Der Goldniederschlag zeichnet sich durch hohe Anlauf- und Korrosionsbeständigkeit

Le A 19 889

aus. Das reduktiv niedergeschlagene Gold weist einen hohen Feingoldgehalt auf. Das niedergeschlagene Gold ist nach der erfindungsgemäßen Vorverkupferung metallisch hochglänzend.

Inden Goldbädern wird als Reduktionsmittel oft Alkalihypophosphit eingesetzt; anstelle dieses Reduktionsmittels kann auch Formaldehyd, Dialkylaminboran oder Natriumborhydrid eingesetzt werden.

Aufgrund der hohen Leitfähigkeit zeigen die vergoldeten textilen Flächengebilde ein hohes Reflexionsvermögen für auftreffende und starkes Absorptionsvermögen in Transmission für durchgehende elektromagnetische Strahlungen. Die vergoldeten textilen Flächengebilde sind beispielsweise hervorragend geeignet für spreiz- oder faltbare Schirmantennen für Radarwellen; eine besondere Anwendung ist im Satellitenbau gegeben; sie können in Raketenköpfen auf kleinstem Raum zusammengefaltet werden, beim Ausfahren im Weltraum treten keine schädlichen Knickungen auf. Metallgeflechte lassen sich nicht auf einem vergleichbar kleinen Raum unterbringen, daneben stört auch deren relativ hohes Gewicht.

Eine besondere Anwendung ist auch in der Medizin gegeben. Durch die Vergoldung wird eine Oberflächenveränderung durch Oxidation oder andere Einflüsse ver-

Le A 19 889

mieden. Die erfindungsgemäßen vergoldeten Flächengebilde lassen sich überall dort anwenden, wo aus Preisgründen auf massive Goldgarne oder Goldgewebe verzichtet
werden muß. Elektroden aus dem goldenen Textilgut
sind anschmiegsam und textilelastisch und können bei
Meßgeräten zur Messung von Herzströmen eingesetzt werden.
Durch die Goldauflage wird erreicht, daß eine allergische Beeinflussung der Haut, wie es beispielsweise
bei Nickel oder Kupfer auftreten kann, verhindert wird,
und eine Veränderung der elektrischen Eigenschaftswerte metallisierender Textilien unter dem Einfluß äußerer Medien, z.B. Schweiß, Oxidationsmittel, nicht erfolgt.

Weiterhin können vergoldeten, textile Antennennetze
für Radasender eingesetzt werden, wenn eine textilelastische Eigenschaft, z.B. Falten, Knäueln usw.
gewünscht wird.

Vergoldete Garne können eingesetzt werden im medizinischen Bereich.

Vergoldete Schnittfasern können als Reflektoren von
elektromagnetischen Wellen verwendet werden.

<u>Le A 19 889</u>

## Beispiel 1

Ein 100 % Polyacrylnitril-Filamentgarngewebe der folgenden textiltechnischen Konstruktion:

Kette und Schuß: 238 dtex (effektiv) aus dtex 220 f 96
Z 51, 38,5 Kettfäden/cm und 27 Schußfäden/cm,

Bindung:        Köper 2/2;

Gewicht:        155 g/m$^2$

wird bei Raumtemperatur in ein salzsaures Bad (pH $\leq$ 1)
einer kolloidalen Palladiumlösung gemäß DE-AS 1 197 720
ohne jegliche Vorbehandlung eingetaucht. Nach Verweilen unter leichter Warenbewegung bis etwa 2 Minuten
wird das Gut entnommen und mit Wasser bei Raumtemperatur
gespült. Dann gibt man es etwa 2 Minuten in eine 5 %ige
Schwefelsäure bei Raumtemperatur. Danach spült man bei
Raumtemperatur mit Wasser ca. 30 Sekunden lang und
trägt es in eine wäßrige Lösung bei Raumtemperatur ein,
bestehend aus 30 g/l Kupfer-II-sulfat, 100 g/l Seig-
nette-Salz und 50 ml/l 37 gew.-%ige Formaldehydlösung.
Das Kupferbad wird mit Natriumhydroxid auf einem pH-
Wert von 11 bis 12 eingestellt.

Innerhalb von 5 Minuten wird die Probe mit einer Kupfermetallschicht von ca. 0,2µm Dicke überzogen.

Diese schwach verkupferte Probe wird sofort in ein alkalisches Goldbad bei 70°C eingebracht. Das Goldbad
ist ein alkalisches cyanidisches Bad mit 6 g/l Kalium-
Gold-cyanid bei pH 10. Sofort nach Einbringen des
feuchten, verkupferten Textils tritt eine bräunliche
Trübung des Goldbades auf und metallisch schimmerndes

Le A 19 889

Gold scheidet sich bereits nach 5 sec auf dem verkupferten Gewebe ab. Je nach gewünschter Schichtdicke läßt man die Probe im Goldbad längere Zeit. Nach ca. 5 Minuten hat sich eine Schichtdicke von durchschnittlich 0,2µm Gold abgeschieden.

Der Oberflächenwiderstand der Probe gemäß DIN 54345 ist 0,4 Ohm.

Beispiel 2

Eine Polyamid-66-wirkware wird 30 Sekunden in dem in Beispiel 1 beschriebenen sauren Palladiumsol behandelt, gewaschen, 2 Minuten in einer 5 gew.-%igen Natronlauge gelegt, gewaschen und 2 Minuten in einer reduktiven alkalischen Kupfersalzlösung bei 23°C verkupfert. Nach 15 Sekunden ist die Probe metallisch verkupfert und schwimmt unter Wasserstoffgasentwicklung nach oben auf. Die Probe wird nach 2 Minuten dem Kupferbad entnommen, gespült, eventuell mit Methanol oder einem anderen flüchtigen Medium entfeuchtet und sofort in eine 75°C warme, alkalische reduktive Goldcyanidlösung gelegt. Beim Einlegen in das Goldbad tritt schlagartig eine bräunliche Trübung auf, nach ca. 5 Sekunden ist bereits die Oberfläche des vorerst verkupferten Polyamidgewebes goldglänzend. Nach 10 Minuten waren 55,5 g Gold pro $m^2$ abgeschieden. Der Widerstand einer quadratischen Fläche betrug 0,7 $\Omega$ .

Le A 19 889

Beispiel 3

Ein 100 % Polyacrylnitrilspinnfasergewebe in Leinwandbindung mit einem Gewicht von 120 g/m$^2$ wird wie in
Beispiel 1 beschrieben zuerst ganz schwach verkupfert
und dann bei pH 10,2 alkalisch vergoldet.

Das vergoldete Gewebe bleibt textilelastisch und hat
insgesamt 33 g Gew.-% Metall aufgenommen, wovon die
Hälfte des Gesamtgewichtes aus Kupfer besteht. Diese
Probe wurde auf ihre Eigenschaft als Mikrowellenabsorber bzw. -reflektor untersucht. Es wurden folgende Werte gemessen:

| Reflexionsverlust in dB | | Absorption in Transmission in dB | |
|---|---|---|---|
| GHz 7 bis 8 | 11 bis 12 | 7 bis 8 | 11 bis 12 |
| 0,5 | 0,5 | 38 (40) | 43 (45) |

Werte in Klammern: Proben gedreht um 90°.

Der Oberflächenwiderstand gemäß DIN 54345 war kleiner
als 10 Ohm.

Beispiel 4

Ein 100 % Polyacrylnitrilspinnfasergewebe in Leinwandbindung mit einem Gewicht von 83 g/m$^2$ wird wie in Bei-

Le A 19 889

spiel 1 beschrieben zuerst ganz schwach verkupfert und dann bei pH 10,2 alkalisch vergoldet.

Das vergoldete Fasergarngewebe bleibt textilelastisch und hat nach einer Metallisierungsdauer von insgesamt 15 Minuten 69,9 % Metall aufgenommen. Dabei besteht die Hälfte der Metallmenge aus Gold. Das Flächengewicht steigt auf 141 g/m$^2$ an. Der Widerstand in Kettrichtung war 0,6 Ohm, in Schußrichtung 0,6 Ohm. Nach DIN 54345 hatte die Probe einen Oberflächenwiderstand von kleiner als 1 Ohm.

Die Probe wurde auf ihre Eigenschaft als Mirkowellenabsorber bzw. -reflektor untersucht. Dabei wurden folgende Werte gemessen:

| Reflexionsverlust in dB | | | Absorption in Transmission in dB | | |
|---|---|---|---|---|---|
| GHz 1-1,5 | 7-8 | 35-36 | 1-1,5 | 7-8 | 35-36 |
| 0,05 | 0,1 | 2,3 | 46(48) | 38(42) | 35( 38) |

Werte in Klammern: Proben gedreht um 90°.

Beispiel 5

Ein Polyester-Baumwoll-spinnfasergewebe in Leinwand-bindung (113 g/m$^2$) im Mischungsverhältnis 50:50 wird wie in Beispiel 1 beschrieben zuerst schwach verkupfert und dann bei pH 10,2 alkalisch vergoldet.

Le A 19 889

Das vergoldete Spinnfasergewebe bleibt textilelastisch und hat nach einer Metallisierungsdauer von insgesamt 15 Minuten 46,6 % Metall aufgenommen. Dabei besteht die Hälfte der abgeschiedenen Metallmenge aus Gold. Das Flächengewicht steigt auf 168,5 g an. Der Widerstand in Kettrichtung war 0,6 Ohm, in Schußrichtung 1,2 Ohm. Nach DIN 54345 hatte die Probe einen Oberflächenwiderstand von kleiner als 1 Ohm.

Diese Probe wurde auf ihre Eigenschaft als Mikrowellenabsorber bzw. -reflektor untersucht. Dabei wurden folgende Werte gefunden:

| Reflexionsverlust in dB | | | Absorption in Transmission in dB | | |
|---|---|---|---|---|---|
| GHz 1-1,5 | 7-8 | 35-36 | 1-1,5 | 7-8 | 35-36 |
| 0,05 | 0,1 | 1,2 | 36(40) | 37(40) | 33( 38) |
| (0,13) | (0,3) | (1,5) | | | |

Werte in Klammern: Probe gedreht um 90°.

Beispiel 6

Ein Spinnfasergarn aus einer Polyacrylnitrilspinnfaser mit der Garnnummer Nm 40/1 wird wie in Beispiel 1 beschrieben vergoldet. Das vergoldete Fasergarn hat insgesamt 39 Gew.-% Metall aufgenommen, wobei die Goldmenge etwa die Hälfte der Metallmenge ausmacht. Das vergoldete Spinnfasergarn zeigt bei 23°C und 50 % rel. Feuchte einen elektrischen Widerstand von 160 Ohm/m. Die

Le A 19 889

textilen Eigenschaften des vergoldeten Garnes haben sich gegenüber denen des unmetallisierten Garnes praktisch nicht verändert, d.h. die Reißfestigkeit und Reißdehnung bleiben gleichwertig.

Beispiel 7

Stapelfasern aus einem Polyacrylnitrilpolymerisat werden ohne jegliche Vorbehandlung in ein salzsaures Bad einer kolloidalen Palladiumlösung bei pH 1 und Raumtemperatur gemäß DE-AS 1 197 720 eingetaucht. Nach Verweilen unter leichtem Rühren zwischen 30 Sekunden bis 2 Minuten wird die Faser dem Bad entnommen und mit Wasser gespült. Dann gibt man sie in eine 5 %ige Natronlauge bei Raumtemperatur. Unter leichtem Rühren und Verteilen der Faser wird das Gut etwa 90 Sekunden bis 2 Minuten behandelt, anschließend entnommen und mit Wasser gespült. Anschließend trägt man die Fasern in ein alkalisches reduktives Kupferbad ein.

Nach einer kurzen Verkupferung von etwa 1 Minute entnimmt man die Fasern dem alkalischen Bad, spült mit Wasser und trägt sie anschließend in ein alkalisches Goldbad bei pH 10 und einer Temperatur von 70°C ein. Bereits nach 5 Sekunden ist ein Goldglanz an der Oberfläche der Stapelfaser zu beobachten. Die Goldschicht wird verstärkt durch Verweilen der Stapelfasern nach weiteren 5 Minuten im Goldbad.

Nach dem Trocknen haben die vergoldeten Stapelfasern einen Oberflächenwiderstand von ca. 21 Ohm gemäß DIN 54345.

Le A 19 889

Patentansprüche

1) Textile Flächengebilde, Garne und Fasern von metallisch glänzendem Aussehen mit einer unteren Metallschicht aus Kupfer oder Nickel/Kupfer mit einer Dicke zwischen 0,05μm bis 1μm und einer oberen Schicht aus Gold.

2) Textile Flächengebilde, Garne und Fasern nach Anspruch 1 mit einem Oberflächenwiderstand von höchstens 10 Ohm, gemessen nach DIN 54345 bei 23°C und 50 % rel. Feuchte.

3) Verfahren zur Herstellung vergoldeter, textiler Flächengebilde, Garne und Fasern nach Anspruch 1 und 2, dadurch gekennzeichnet, daß die untere Schicht aus Kupfer oder Nickel/Kupfer und die Deckschicht aus Gold stromlos naßchemisch niedergeschlagen werden.

4) Verwendung der vergoldeten textilen Flächengebilde nach Anspruch 1 und 2 als reflektierendes Material für Mikrowellen und Hochfrequenzstrahlung.

5) Verwendung der vergoldeten textilen Flächengebilde nach Anspruch 1 und 2 zur Abschirmung von Mikrowellen und Hochfrequenzstrahlung.

6) Verwendung der vergoldeten textilen Garze nach Anspruch 1 bis 3 zur Herstellung stromführender Elemente z.B. Kabel.

Le A 19 889

7)  Verwendung der vergoldeten textilen Fasern nach
    Anspruch 1 bis 3 zur Herstellung reflektierender
    Elemente für elektromagnetische Strahlung.